# EUROPEAN PATENT APPLICATION

(11) **EP 2 421 022 A2**
(43) Date of publication of application: **22.02.2012**
(21) Application number: 11178003.7
(22) Date of filing: 18.08.2011
(51) Int. Cl.: H01J 37/08, H01J 37/317, C23C 14/35, H01J 37/34, B82Y 40/00, B82Y 20/00, H01L 31/0256, H01L 31/18

(54) **Production of nanoparticles**

(30) Priority: 18.08.2010 GB 1013861
(71) Applicant: Mantis Deposition Limited, Thame, Oxfordshire OX9 3BX (GB)
(72) Inventor: Kean, Alistair, Thame, Oxfordshire OX9 3BX (GB); Saranu, Srinivas, Aylesbury, Buckinghamshire HP21 8PA (GB)
(74) Representative: Lord, Michael

(57) **Abstract**

An apparatus (10) comprising a source (20) for generating a flow of particles substantially along an axis; a first chamber (12), having a first diameter in a direction transverse to the axis, in which the particles agglomerate together into nanoparticles (32) of a first size; and a second chamber (14), coupled to the first chamber, in which the nanoparticles agglomerate together into nanoparticles (34) of a second, greater size. The second chamber has a second diameter transverse to the axis that is narrower than the first diameter.

## Description

### FIELD OF THE INVENTION

The present invention relates to the production of nanoparticles.

### BACKGROUND ART

Metal nanoparticles interact strongly with light due to the generation of localized surface plasmons. It has been shown that the strong scattering of light by metal nanoparticles can be used to improve the efficiency of solar cells (see "Plasmonic enhancement of silicon solar cells", by Temple T and Bagnall D, Technical Digest of the International PVSEC-17, 2007).

In thin-film photovoltaic cells without nanoparticles, a large portion of photons incident on the film pass through or are reflected without generating the electron-hole pair that creates a potential difference in the cell. This is the result of photons either missing the active region, or passing through it without interaction due to the relatively short path length of photons incident on the cell at right angles. By inserting nanoparticles into the active area of the cell, and by appropriate design of the nanoparticles, light can be scattered sideways (i.e. within the plane of the thin film). The scattered photons therefore experience a longer path through the active region, and are more likely to interact and generate electron-hole pairs. This greatly increases the efficiency of the cell, and is known as "plasmonic light harvesting".

Typical techniques used to add nanoparticles to the surface of a thin film photovoltaic include nanoparticles which are synthesized chemically and are subsequently deposited onto the surface of the photovoltaic using solvents. Chemically generated nanoparticles tend to be 'functionalised' with hydrocarbon impurities which degrades their physical properties.

### SUMMARY OF THE INVENTION

The technique described here provides a method which allows pure nanoparticles to be deposited directly onto the surface, or any level of the photovoltaic structure.

In order to scatter photons sideways towards the active region, the size and shape of the nanoparticles must be carefully chosen. The greatest efficiency has been shown for nanoparticles having a diameter of 50nm or more. Nanoparticles produced by techniques disclosed in our previous disclosures typically have a diameter that is between 0.5 and 20 nm.

The present invention is therefore directed towards an apparatus and method for reliably and efficiently producing nanoparticles that are greater in size than previously possible. Apparatus according to embodiments of the present invention is capable of producing nanoparticles between 20 and 160 nm in diameter. These can then be used in thin-film photovoltaic cells or in other contexts.

In a first aspect of the present invention, there is provided an apparatus comprising a source for generating a flow of particles substantially along an axis; a first chamber, having a first diameter in a direction transverse to the axis, in which the particles agglomerate together into nanoparticles of a first size; and a second chamber, coupled to the first chamber, in which the nanoparticles agglomerate together into nanoparticles of a second, greater size. The second chamber has a second diameter transverse to the axis that is narrower than the first diameter.

In one embodiment, the coupling between the first and second chambers comprises a constriction having a third diameter transverse to the axis that is narrow than the second diameter. The constriction may be located on the axis.

In a further embodiment, the apparatus further comprises a gas flow source from the first chamber into the second chamber. The gas flow source may be arranged to direct the flow through the first chamber past the source and then into the second chamber.

The gas pressure in the second chamber may be higher than the gas pressure in the first chamber, facilitating the generation of nanoparticles with greater diameter in the second chamber. For example, the gas pressure in the first chamber may be between about 10⁻⁴ atmospheres and about 10⁻² atmospheres, and the gas pressure in the second chamber at a higher level.

In a second aspect of the present invention, a method of producing nanoparticles is provided, the method comprising: generating a stream of particles along an axis; in a first chamber, allowing the particles to agglomerate together into nanoparticles of a first size, the first chamber having a first diameter in a direction transverse to the axis; and in a second chamber coupled to the first chamber, allowing the nanoparticles to agglomerate together into nanoparticles of a second, greater size. The second chamber has a second diameter transverse to the axis that is narrower than the first diameter.

### BRIEF DESCRIPTION OF THE DRAWINGS

An embodiment of the present invention will now be described by way of example, with reference to the accompanying figures in which;
Figure 1 shows the claimed apparatus in a schematic form;
Figure 2 shows a flowchart of a method according to embodiments of the present invention; and
Figures 3 & 4 show an atomic force microscope image of nanoparticles deposited onto silicon using the method of the present invention.

### DETAILED DESCRIPTION OF THE EMBODIMENTS

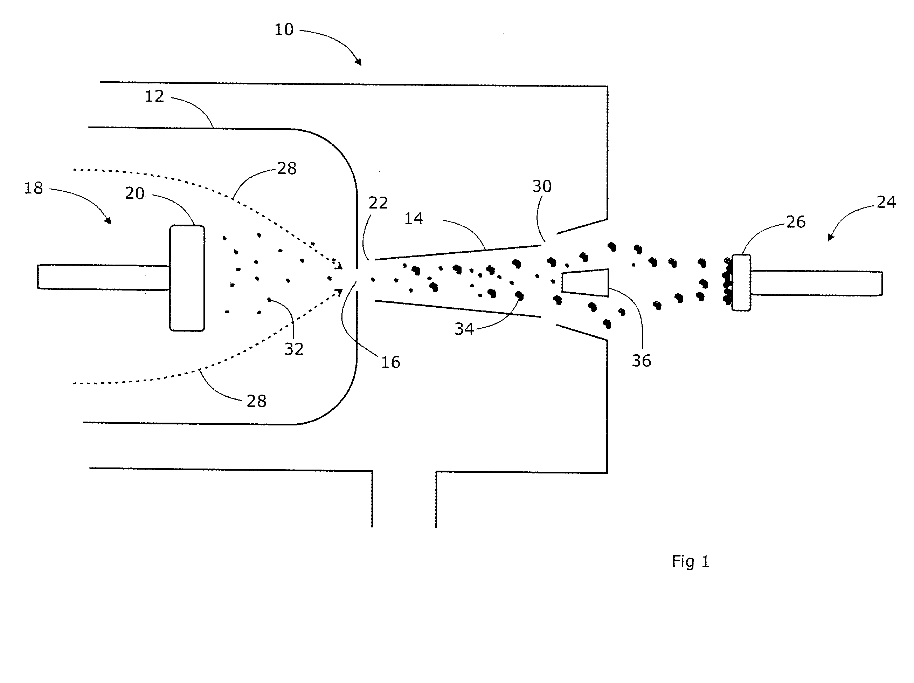

Figure 1 shows, in schematic form, an apparatus 10 according to embodiments of the present invention.

The apparatus comprises two main chambers: a first, relatively wide chamber 12, in which particles are ionized and agglomerated into relatively small nanoparticles; and a second, relatively narrow chamber 14, in which the nanoparticles themselves agglomerate together into relatively large nanoparticles. After the second chamber 14, the relatively large nanoparticles are collected. The first chamber 12 is coupled to the narrower second chamber 14 via a constriction 16, which may be narrower than the second chamber 14.

The first chamber 12 contains a magnetron sputtering device 18 to generate a vapour of particles. The device 18 comprises a source 20 of particles. The interior of the first chamber 12 contains an inert gas at a relatively high pressure of a 10⁻² mbar or more, say up to 5x10⁻¹mbar (i.e., still well below atmospheric pressure). Alternatively, any method capable of creating an atomic vapour can be used, such as evaporative techniques (e.g. thermal evaporation, MBE) or chemical techniques (e.g. CVD).

The inert gas is fed into the chamber 12 from a point behind the magnetron 12 and extracted from one or more exit apertures 22 in a furthermost portion of the second chamber 14 (i.e. in a portion of the second chamber 14 nearer its furthermost end than the constriction 16). This creates a gas flow through the first chamber as indicated by arrows 28 and establishes a drift of the vapour towards the constriction 16 and into the second chamber. The gas flow then exits via the exit apertures 22 (see arrows 30 in Figure 1). During its transit to the constriction 16, the vapour condenses to form a nanoparticle cloud 32. That is, the atomic particles condense to form nanoparticles 32 of a first size (e.g. 0.5 to 20 nm in diameter).

The narrowness of the constriction 16 may ensure that only nanoparticles with a trajectory lying substantially along the axis of the apparatus 10 are allowed through to the second chamber 14. It also forces nanoparticles into closer proximity with one another, by action of the gas flow 28 towards the constriction 16.

In the second chamber 14, the relatively narrow diameter forces the nanoparticles 32 themselves to condense and agglomerate into larger nanoparticles 34 (having a diameter of between 20 and 200 nm). That is, the pressure inside the second chamber 14 is higher than that in the first chamber 12 (Bernouilli's principle applying only to noncompressible fluids, while the inert gas is at sufficiently low pressure that it may be compressed even at low flow rates). The relatively higher pressure results in more collisions between particles, and so a greater likelihood that nanoparticles will collide with one another and coalesce to form a nanoparticle having an even greater diameter. The relatively high gas pressure may also be significant in reducing the kinetic energy of the nanoparticles through collisions. Thus, the nanoparticles 34 spend a greater time in the second chamber 14 in which to agglomerate into larger nanoparticles.

After the second chamber 14, the apparatus 10 comprises a means 24 for collecting nanoparticles. By using magnetron sputtering, a high fraction of the nanoparticles produced are negatively charged. This allows the particles to be accelerated electrostatically across a vacuum to a substrate or object 26, and thus gain kinetic energy. This can be achieved by raising the substrate or object to a suitably high potential. Non-conductive substrates can be placed behind a conductive mask having an appropriately shaped aperture in the line of sight of the particle beam. When used in the manufacture of photovoltaic cells, for example, the substrate 26 can be glass or plastic coated with a layer of conducting material (e.g. molybdenum).

The kinetic energy acquired in flight is lost on impact by way of deformation of the particles. The degree of deformation naturally depends on the energy imparted to the particles in flight. At very high energies, the nanoparticle structure may be lost and the resultant film will be essentially bulk material. At very low energies, the process will be akin to condensation and the film may be insufficiently adherent. Between these extremes, there is scope for deformation of the particles that is mild enough for the surface of the film to retain nanoparticulate properties but for the interface with the substrate to be adherent.

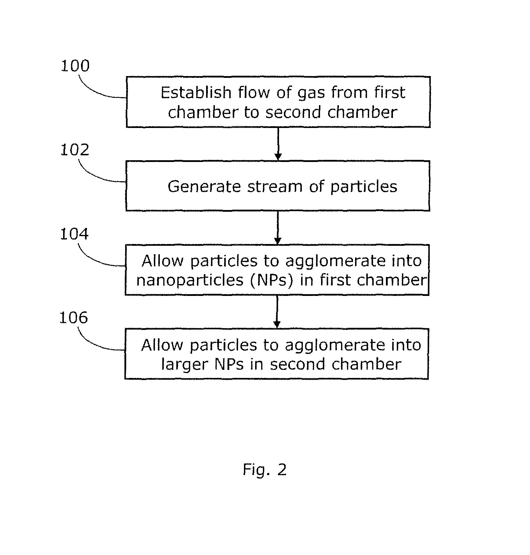

Figure 2 shows a flowchart of a method according to embodiments of the present invention.

In step 100, a flow of inert gas is established from the first chamber into the second chamber. In step 102, a stream of particles is generated, for example through magnetron sputtering (although alternative methods will be familiar to those skilled in the art). In step 104, the stream of particles is allowed to agglomerate into nanoparticles of a first size. This is achieved through a relatively high gas pressure inside the first chamber which causes the particles to lose kinetic energy through collisions. In step 106, the nanoparticles pass into the second chamber and are allowed to agglomerate into nanoparticles of a second, greater size. This is achieved through a yet higher gas pressure in the second chamber as a result of the narrower dimensions thereof.

Thus the present invention provides an apparatus for generating nanoparticles of greater diameter than previously possible. The apparatus comprises two agglomeration zones: in a first, relatively wide chamber, particles agglomerate to form nanoparticles of a first diameter; in a subsequent, relatively narrow chamber, the nanoparticles agglomerate together to form nanoparticles of a second, greater diameter.

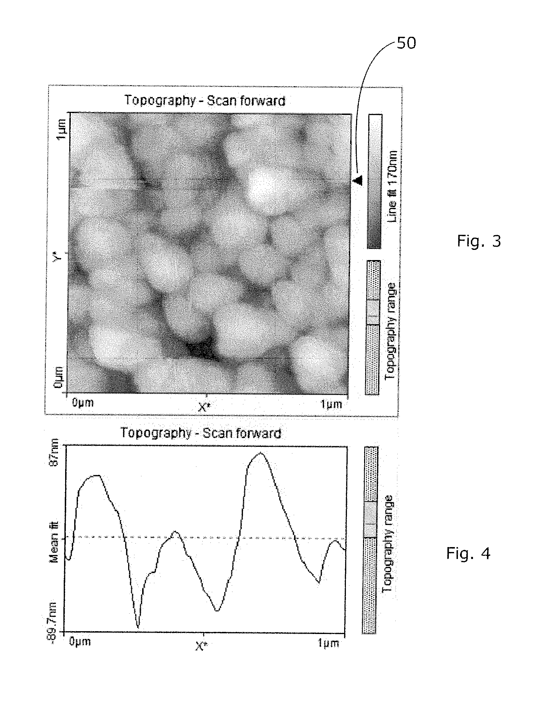

Figures 3 and 4 show the results that can be obtained by use of this method. Figure 3 is an atomic force microscope image of nanoparticles deposited onto silicon using the method described in this patent. Figure 4 shows a topography scan of the line indicated by arrow 50, which shows a mean nanoparticle diameter of around 100nm.

It will of course be understood that many variations may be made to the above-described embodiment without departing from the scope of the present invention.

## Claims

1. Apparatus for the production of nanoparticles, comprising:
a source for generating a flow of particles substantially along an axis;
a first chamber, having a first diameter in a direction transverse to the axis, in which the particles agglomerate together into nanoparticles of a first size; and
a second chamber, coupled to the first chamber, in which the nanoparticles agglomerate together into nanoparticles of a second, greater size,
wherein the second chamber has a second diameter transverse to the axis that is narrower than the first diameter.

2. Apparatus as claimed in claim 1, in which the coupling between the first and second chambers comprises a constriction having a third diameter transverse to the axis that is narrow than the second diameter.

3. Apparatus as claimed in claim 2, wherein the constriction is located on the axis.

4. Apparatus as claimed in any one of the preceding claims, further comprising a gas flow source from the first chamber into the second chamber.

5. Apparatus as claimed in claim 4 wherein the gas flow source is arranged to direct the flow through the first chamber past the source and then into the second chamber.

6. Apparatus as claimed in any one of the preceding claims, wherein the gas pressure in the first and second chambers is less than atmospheric pressure.

7. Apparatus as claimed in claim 6, wherein the gas pressure in the second chamber is higher than the gas pressure in the first chamber.

8. Apparatus as claimed in claim 6 or 7, wherein the gas pressure in the first chamber is between about 10⁻⁴ atmospheres and about 10⁻² atmospheres.

9. Apparatus as claimed in any one of the preceding claims, further comprising a target substrate, onto which the nanoparticles of a second size are deposited.

10. Apparatus as claimed in claim 9, wherein the target substrate is at an electric potential controlled such that the nanoparticles of a second size are deposited on the target without disassociating.

11. A method of producing nanoparticles, comprising:
generating a stream of particles along an axis;
in a first chamber, allowing the particles to agglomerate together into nanoparticles of a first size, the first chamber having a first diameter in a direction transverse to the axis; and
in a second chamber coupled to the first chamber, allowing the nanoparticles to agglomerate together into nanoparticles of a second, greater size, the second chamber having a second diameter transverse to the axis that is narrower than the first diameter.

12. A method as claimed in claim 11, wherein the nanoparticles of a first size pass through a constriction between the first and second chambers having a third diameter transverse to the axis that is narrow than the second diameter.

13. A method as claimed in claim 12, wherein the constriction is located on the axis.

14. A method as claimed in claim 11 or claim 12, further comprising the step of establishing a flow of gas through the first chamber and into the second chamber.
